(19) Europäisches Patentamt
European Patent Office
Office européen des brevets

(11) **EP 3 382 411 B1**

(12) **EUROPÄISCHE PATENTSCHRIFT**

(45) Veröffentlichungstag und Bekanntmachung des Hinweises auf die Patenterteilung:
**04.09.2019 Patentblatt 2019/36**

(51) Int Cl.:
**G01R 33/38** *(2006.01)*  **F17C 3/00** *(2006.01)*
**G01R 33/3815** *(2006.01)*

(21) Anmeldenummer: **18163407.2**

(22) Anmeldetag: **22.03.2018**

(54) **KRYOSTATANORDNUNG MIT EINEM HALSROHR MIT EINER TRAGENDEN STRUKTUR UND EIN DIE TRAGENDE STRUKTUR UMGEBENDES AUSSENROHR ZUR VERRINGERUNG DES KRYOGENVERBRAUCHS**

CRYOSTATIC DEVICE WITH A NECK PIPE WITH A LOAD-BEARING STRUCTURE AND AN OUTER TUBE SURROUNDING THE LOAD BEARING STRUCTURE FOR REDUCING CRYOGENIC CONSUMPTION

DISPOSITIF FORMANT CRYOSTAT POURVU DE COL TUBULAIRE À UNE STRUCTURE PORTEUSE ET UN COL TUBULAIRE ENTOURANT LA STRUCTURE PORTEUSE DESTINÉ À RÉDUIRE LA CONSOMMATION DE CRYOGÈNE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.03.2017 DE 102017205279**

(43) Veröffentlichungstag der Anmeldung:
**03.10.2018 Patentblatt 2018/40**

(73) Patentinhaber: **Bruker BioSpin AG**
**8117 Fällanden (CH)**

(72) Erfinder:
• **Wikus, Patrick**
**8309 Nürensdorf (CH)**

• **Bonn, Steffen**
**8050 Zürich (CH)**

(74) Vertreter: **Kohler Schmid Möbus Patentanwälte Partnerschaftsgesellschaft mbB**
**Gropiusplatz 10**
**70563 Stuttgart (DE)**

(56) Entgegenhaltungen:
EP-A2- 1 736 723     DE-B3-102004 060 832
JP-A- H0 560 295     US-A- 5 220 800
US-A- 5 347 818      US-A1- 2011 219 785

**Beschreibung**

Die Erfindung betrifft eine Kryostatanordnung mit einem Vakuumbehälter und einem Kryogenbehälter, der innerhalb des Vakuumbehälters angeordnet ist, wobei der Vakuumbehälter mindestens ein Halsrohr mit einer tragenden Struktur und ein die tragende Struktur umgebendes Außenrohr aufweist, wobei das Halsrohr zum Kryogenbehälter führt und wobei über das Halsrohr eine räumliche Verbindung eines inneren Volumens des Kryogenbehälters zu einem Bereich außerhalb des Vakuumbehälters hergestellt werden kann, sodass kryogenes Fluid aus dem Kryogenbehälter in einen Bereich außerhalb des Vakuumbehälters strömen kann oder umgekehrt.

Eine solche Kryostatanordnung ist etwa aus der US-A 5,220,800 bekannt geworden.

Hintergrund der Erfindung

Die vorliegende Erfindung betrifft allgemein den Bereich der Kühlung technischer Systeme, welche im Betrieb auf sehr tiefen (=kryogenen) Temperaturen gehalten werden sollen/müssen. Derartige Systeme können etwa supraleitende Magnetanordnungen umfassen, wie sie etwa auf dem Gebiet der Magnetresonanz, beispielsweise in MRI-Tomographen oder NMR-Spektrometern eingesetzt werden. Solche supraleitenden Magnetanordnungen werden üblicherweise mit flüssigem Helium als kryogenem Fluid gekühlt.

Ein wichtiges Merkmal eines supraleitenden NMR Magnetsystems ist der Heliumverbrauch im Betrieb. Der Heliumverbrauch hat zum einen Auswirkungen auf die laufenden Kosten, die für den Betrieb des Systems aufgewendet werden müssen; zum anderen ist der Nachfüllintervall maßgeblich vom Heliumverbrauch abhängig. Je geringer der Nachfüllintervall, desto länger kann das System störungsfrei betrieben werden. Bei konstantem Nachfüllintervall kann ein System mit niedrigerem Heliumverbrauch auch kompakter ausgeführt werden, da der Heliumtank kleiner gestaltet werden kann. Dies hat zur Folge, dass das System billiger in der Produktion wird, und die Anforderungen an den Aufstellungsort (z.B. Raumhöhe) geringer werden. Eines der Entwicklungsziele für supraleitende Magnetsysteme ist daher die Reduzierung des Verbrauchs von flüssigem Helium, was bei badgekühlten Systemen gleichbedeutend mit einer Reduktion der Wärmelast auf den Heliumtank ist.

In typischen Badkryostaten wird ein Großteil der gesamten Wärmelast auf den Heliumtank durch Wärmeleitung in den sogenannten "Halsrohren" hervorgerufen. Diese Halsrohre verbinden den Tank, in dem das flüssige Kryogen gespeichert ist, mit der Außenwelt. Durch die Halsrohre kann die kryogene Flüssigkeit nachgefüllt werden, und sie kann abströmen (auch mit hoher Flussrate, wie z.B. während eines Magnet-Quenches oder eines plötzlichen Verlusts der Vakuumisolation).

Die Halsrohre sind auch nötig, um Zugang zu im Tank befindlichen Komponenten (z.B. zu den elektrischen Anschlüssen einer Magnetspule) zu erlangen. In vielen Kryostaten tragen die Halsrohre auch das Gewicht des Tanks. Einer der größten Beiträge zur Gesamtwärmelast auf den Heliumtank stammt von diesen Halsrohren, wobei die Wärmeleitung im Rohr der dominante Mechanismus ist.

Üblicherweise werden Halsrohre besonders dünnwandig ausgeführt; Wandstärken im Bereich weniger Zehntelmillimeter sind keine Seltenheit. Die Halsrohre werden typischerweise aus einem Material mit geringer Wärmeleitfähigkeit hergestellt. Die Wand des Halsrohres darf nicht gasdurchlässig sein, damit die Vakuumisolation des Kryostaten nicht kontaminiert und damit unbrauchbar wird. Außerdem muss das Halsrohrmaterial aus Sicht der Verbindungstechnik gut geeignet sein (Schweißbarkeit, Lötbarkeit). In vielen Fällen kommt Edelstahl zum Einsatz.

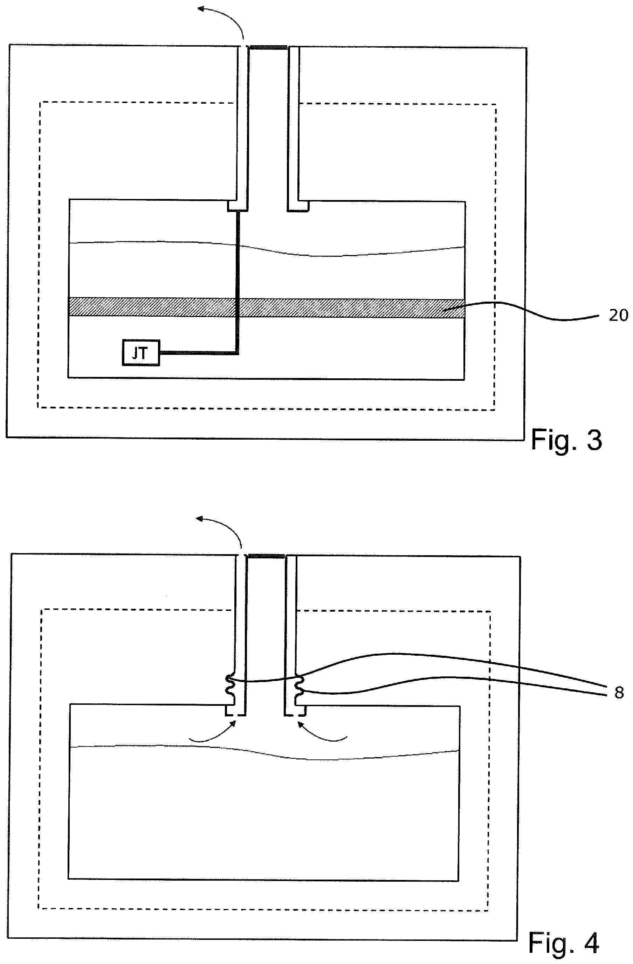

Die eingangs zitierte US-A 5,220,800 offenbart eine gattungsgemäße Kryostatanordnung für ein NMR-Magnetsystem mit supraleitender Magnetspule. Die Kryostatanordnung weist ein doppelwandiges Halsrohr auf, durch dessen Ringspalt eine Strömung von Helium erfolgen kann (siehe etwa dortige Figur 4).

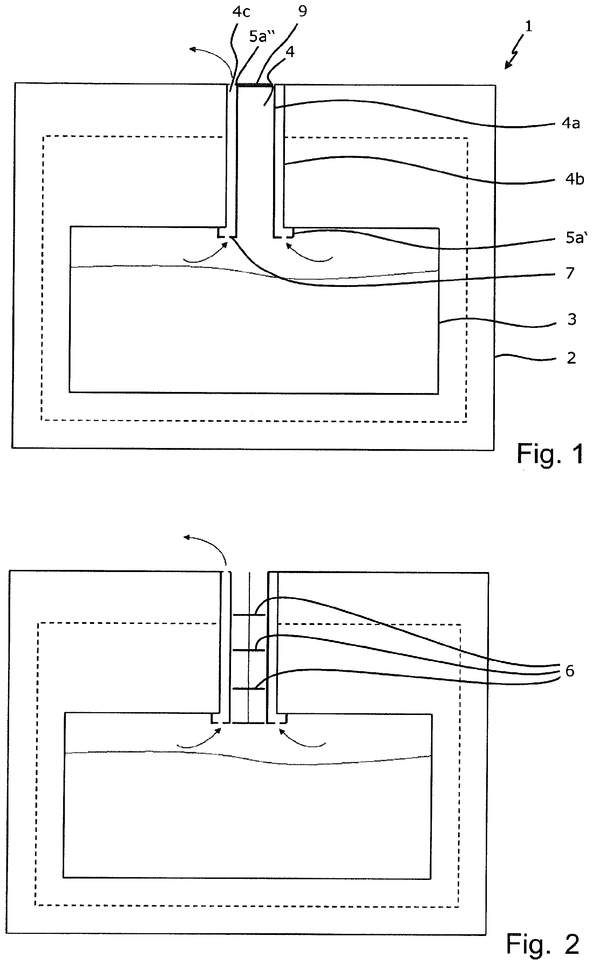

Zum mechanischen Aufbau sowie der Befestigung von Außen- und Innenrohr macht die US-A 5,220,800 folgende Angaben:
*"The manner in which the chambers 1 and 2, radiation shields 21 and 22, and cooling tank 23 are suspended in the cryostat 4 on suspension tubes 30 is depicted only schematically in FIG. 1. The connecting elements used are thinwalled tubes or bundles of three centering rods 26 each, a few millimeters in diameter, which have extremely low thermal conductivity and high tensile strength."*

Die mechanische Aufhängung des Halsrohres und die Bereitstellung einer strömungstechnischen Diffusionsbarriere sind hier also zwingend physisch gemeinsam, insbesondere mittels ein und desselben Materials ausgeführt. Eine getrennte Optimierung der rein mechanischen Funktion einer Aufhängung einerseits sowie der strömungstechnischen Funktion einer Diffusionsbarriere andererseits, etwa hinsichtlich der Materialauswahl nach Art und Stärke sind daher gemäß der Lehre von US-A 5,220,800 weder möglich noch angedacht.

Aufgabe der Erfindung

Der vorliegenden Erfindung liegt gegenüber dem oben diskutierten Stand der Technik die -im Detail betrachtet relativ anspruchsvolle und komplexe-Aufgabe zugrunde, bei einer Kryostatanordnung der eingangs beschriebenen Art mit möglichst unaufwändigen technischen Mitteln den von den Halsrohren stammenden Wärmeeintrag in den Kryogenbehälter -in der Regel einen Heliumtank- deutlich zu verringern.

Kurze Beschreibung der Erfindung

Diese Aufgabe wird durch die vorliegende Erfindung auf ebenso überraschend einfache wie wirkungsvolle Weise dadurch gelöst, dass bei einer Kryostatanordnung der eingangs definierten Art das Halsrohr so gestaltet ist, dass die Funktionen einer mechanischen Befestigung des Kryogenbehälters einerseits und einer Dichtigkeit der Halsrohrwand andererseits voneinander getrennt sind, indem zu einer mechanischen Aufhängung des Kryogenbehälters am Vakuumbehälter dienenden Teile des Halsrohrs einerseits und zur Errichtung einer Diffusionsbarriere zwischen dem Innenraum des Kryogenbehälters und dem Innenraum des Vakuumbehälters dienenden Teile des Halsrohrs andererseits räumlich voneinander getrennt angeordnet und aus jeweils unterschiedlich optimierten Materialien gefertigt sind, dass die tragende Struktur aus Kunststoff gefertigt ist und an ihren beiden Enden jeweils einen Metallfortsatz zur Verbindung mit dem Vakuum- bzw. dem Kryogenbehälter aufweist, dass die tragende Struktur das Gewicht des Kryogenbehälters trägt und aus einem Material gefertigt ist, bei welchem für das Verhältnis $\sigma/\theta$ von maximal zulässiger mechanischer Spannung $\sigma$, mit $\sigma > 100$ MPa, zum Integral $\theta$ der Wärmeleitfähigkeit $\lambda$ über den Temperaturbereich $\Delta T$ zwischen 300 K und 4 K, mit $\theta < 300$ W/m, gilt: $\sigma/\theta > 1/3$ (MPa·m)/W, und dass das Außenrohr aus einem Material gefertigt ist, durch welches kryogenes Fluid nicht oder nur in praktisch nicht-messbarer Menge diffundieren kann, und welches mit anderen Komponenten der Kryostatanordnung fluiddicht verbunden ist, so dass die resultierende integrale Leckrate aus dem Kryogenbehälter in den Vakuumbehälter kleiner ist als $10^{-4}$ Pa.l/s ($10^{-6}$ mbar·l/s).

Die Grundidee der vorliegenden Erfindung besteht darin, das in der Regel doppelwandig ausgeführte Halsrohr so zu gestalten, dass die Funktionen der mechanischen Befestigung des Tanks einerseits und der Herstellung der Dichtigkeit (minimale Permeation des Kryogens durch die Halsrohrwand) andererseits voneinander getrennt sind. Diese Vorgehensweise ermöglicht erst eine getrennte Optimierung.

Die mit der vorliegenden Erfindung erzielbare Verringerung der Wärmelast hat jedoch nicht nur für supraleitende Magnetsysteme hohe Relevanz. Aus diesem Grund ist die Erfindung auch auf andere Bereiche der Kryotechnik (z.B. Speicherung von Kryogenen wie Helium oder Wasserstoff) nutzbringend anwendbar.

Mit der vorliegenden Erfindung werden insbesondere folgende Vorteile erzielt:
Die Wärmelast auf den Kryogentank kann durch die hinsichtlich seiner thermischen Eigenschaften effizientere Gestaltung des Halsrohrs deutlich verringert werden.

Bei aktiv gekühlten Systemen ermöglicht dies den Einsatz eines Kühlers mit geringerer Kühlleistung, was sich zum Beispiel vorteilhaft auf den Stromverbrauch und die Systemkosten auswirkt.

Bei badgekühlten Systemen führt dies zu einer Verringerung der Abdampfrate des kryogenen Fluids. Dies hat zum einen eine deutliche Verringerung der Betriebskosten zur Folge, auf der anderen Seite vergrößert sich auch das Zeitintervall, in dem das kryogene Fluid (typischerweise Helium) nachgefüllt werden muss, was die Störungen bei langandauernden Kernspinresonanz-Messungen reduziert und insgesamt die Verfügbarkeit des Systems für NMR-Messungen erhöht.

Abdampfendes Kryogen befindet sich im thermischen Kontakt mit Teilen des Halsrohres. Dies ermöglicht es, die Enthalpie des kalten Gases zu nutzen, um Wärme, die durch Wärmeleitung im Halsrohr vom warmen zum kalten Ende fließt, "abzufangen". Entsprechende nicht-fluiddichte Tragestrukturen befinden sich beim Stand der Technik stets im Vakuum, wodurch ihnen das Merkmal einer thermodynamisch vorteilhaften Abgaskühlung fehlt.

Bevorzugte Ausführungsformen und Weiterbildungen der Erfindung

Ganz besonders bevorzugt ist eine Ausführungsform der erfindungsgemäßen Kryostatanordnung, bei der die tragende Struktur in Form eines Innenrohres ausgebildet ist, und über das Innenrohr eine räumliche Verbindung des inneren Volumens des Kryogenbehälters zu einem Bereich außerhalb des Vakuumbehälters hergestellt werden kann, sodass kryogenes Fluid aus dem Kryogen-behälter in einen Bereich außerhalb des Vakuumbehälters strömen kann oder umgekehrt. Über das Innenrohr kann dann ein verhältnismäßig großer Zugang zum Kryogentank geschaffen werden, über den z.B. elektrische Verbindungen zu einer supraleitenden Magnetspule hergestellt werden können. Außerdem steht so ein großer Querschnitt zu Verfügung, um Kryogen mit hoher Flussrate aus dem Heliumtank ohne unzulässig hohen Druckanstieg aus dem Kryogentank entweichen zu lassen (z.B. im Falle eines Quenches einer supraleitenden Magnetspule oder im Falle eines Vakuumbruchs).

Eine besonders einfach zu realisierende Weiterbildung dieser Ausführungsform sieht vor, dass das Außenrohr in direktem, vorzugsweise thermisch gut leitenden, Kontakt mit dem Innenrohr steht. Die Diffusionsbarriere kann direkt am tragenden Rohr aufgebracht werden. Innen- und Außenrohr stehen deshalb in gutem thermischen Kontakt miteinander. Kryogen, das durch das Innenrohr abströmt, kühlt in erster Linie das Innenrohr, ist aber -da die Rohre in gutem thermischen Kontakt stehen- auch in der Lage, Wärme aus dem Außenrohr zu absorbieren. Die größten Vorteile dieser Ausführungsform liegen in der Einfachheit der Konstruktion und der thermodynamischen Effizienz.

Bei einer alternativen Weiterbildung kann das Außenrohr zur tragenden Struktur beabstandet sein und zwischen dem Innenrohr und dem Außenrohr ein Spalt offenbleiben. Dieser Spalt kann auf vielfältige Art genutzt werden, wie in mehreren der folgenden Ansprüche beschrieben ist. So ist es zum Beispiel möglich, Kryogen durch den Spalt zwischen der tragenden Struktur und dem Außenrohr strömen zu lassen, was eine besonders effiziente Kühlung der beiden Rohrwände ermöglicht. Außerdem ist es möglich, den Spalt als Pumpleitung für den Betrieb eines Joule-Thompson-Kühlers zu verwenden.

Wird die tragende Struktur in dieser Ausführungsform als Innenrohr realisiert, das im Normalbetrieb verschlossen ist, können die bereits oben genannten Vorteile (z.B. großer Querschnitt für elektrische Verbindungen und Quenchfall/Vakuumbruch) realisiert werden, während gleichzeitig die "Abgaskühlung" des Halsrohres durch entsprechende Wahl der Spaltgeometrie optimiert werden kann (z.B. kleine Spaltmaße für hohe Wärmeübergangskoeffizienten).

Besonders bevorzugt sind Varianten dieser Weiterbildung, bei denen das Außenrohr und die tragende Struktur durch mehrere axial angeordnete, radial verlaufende Wärmebrücken miteinander verbunden sind. Dadurch lässt sich auch bei einer Beabstandung der tragenden Struktur vom Außenrohr sicherstellen, dass guter thermischer Kontakt zwischen den beiden Rohren und im Innenrohr oder Spalt strömendem Fluid herrscht. Solche Wärmebrücken können zum Beispiel Kupfer-Berylliumfedern sein, die thermisch leitend an der tragenden Struktur befestigt werden. Wird die tragende Struktur dann bei der Systemmontage ins Außenrohr geschoben, drücken sich die Kupfer-Berylliumfedern an die Innenseite des Außenrohres, wodurch ein guter Wärmeübergang erzielt werden kann.

Bei weiteren vorteilhaften Varianten weist der Spalt zwischen einem Innenrohr und dem Außenrohr an dem Kryogenbehälter näherliegenden Ende des Halsrohrs eine Strömungsdrossel auf. Wenn der Eingang des Spalts durch eine Drossel geschützt ist, und der raumtemperaturseitige Auslass des Spalts ausreichend groß dimensioniert ist, muss der Quench-Druck bei der Dimensionierung des äußeren Rohrs nicht berücksichtigt werden, da sich im Spalt kein hoher Druck aufbauen kann. Dies macht es möglich, das Außenrohr, das zur Herstellung ausreichender Dichtigkeit tendenziell aus einem Material mit größerer Wärmeleitfähigkeit gefertigt werden muss (z.B. Edelstahl), besonders dünnwandig auszuführen, was wiederum die axiale Wärmeleitung im Außenrohr minimiert.

Das Innenrohr wird typischerweise eine Wandstärke zwischen 0,5 mm und 3 mm aufweisen. Um den Wärmeeintrag in den Kryogenbehälter zu minimieren, sollte die Wandstärke so dünn wie möglich sein - gerade so dünn, wie die Anforderungen an die mechanische Festigkeit zulassen. Für Magnetspulen in der Größenordnung, wie die Anmelderin sie derzeit herstellt, ergibt sich daraus für typische Halsrohrdurchmesser und die weitere unten erwähnten Materialien die oben angegebene Spanne für Wandstärken.

Bei weiteren bevorzugten Ausführungsformen der Erfindung ist die tragende Struktur aus faserverstärktem Kunststoff, insbesondere aus GFK, besonders bevorzugt aus dem Faserverbundwerkstoff G10, gefertigt. Bei GFK ist die minimal erreichbare Wandstärke durch fertigungstechnische Limitationen beschränkt. GFK kann nämlich nicht beliebig dünn gemacht werden. G10 ist ein in der Kryotechnik weit verbreiteter Werkstoff, der sich durch ein besonders niedriges Verhältnis von Wärmeleitfähigkeit zu Festigkeit auszeichnet. Für Befestigungsstrukturen mit geringer Wärmeleitfähigkeit ist G10 daher ideal geeignet. Außerdem ist G10 verhältnismäßig billig, und kann in eine Vielzahl von Formen gebracht werden. Metallische Anschlussstücke können durch Kleben einfach mit G10 Bauteilen verbunden werden, oder, was noch besser ist, direkt bei der Herstellung der G10 Komponente mitlaminiert werden. Beim Einsatz von Faserverbundwerkstoffen eröffnet sich die Möglichkeit, die Fasern innerhalb der Matrix so zu orientieren, dass die anisotropen Eigenschaften der Faser optimal genutzt werden, und z.B. die Zugfestigkeit eines Tragrohres in axialer Richtung maximiert wird.

Gemäss der Erfindung weist die tragende Struktur aus Kunststoff an ihren beiden Enden jeweils einen Metallfortsatz, vorzugsweise aus Edelstahl, auf. Typischerweise werden die Innenrohre mit metallischen Teilen im Kryostaten (z.B. mit dem Vakuumbehälter oder dem Kryogenbehälter) verbunden. Die Montage des Kryostaten gestaltet sich besonders einfach, wenn das Kunststoffrohr schon mit metallischen Hülsen an seinen Enden ausgestattet ist. Dann muss während der Montage des Kryostaten keine Metall-Kunststoffverbindung hergestellt werden. Dies ist vorteilhaft, da zuverlässige Metall-Kunststoffverbindungen während des Montageprozesses technologisch schwierig herzustellen sind, allerdings leicht direkt in die Herstellung der tragenden Struktur aus Kunststoff integriert werden können (z.B. durch direktes Vergießen der Metallhülse mit Kunststoff), oder ohne weiteres in einem separaten Arbeitsgang vor der Montage des Kryostaten hergestellt werden können (z.B. durch Kleben). Mit metallischen Hülsen an den Rohrenden kann einfach geschweißt werden. Schweißen ist ein Prozess, der leicht in den Montageprozess eines Kryostaten integriert werden kann.

Besonders bevorzugt sind Weiterbildungen dieser Ausführungsformen, bei denen die Metallfortsätze jeweils eine Länge zwischen 20 mm und 100 mm, vorzugsweise etwa 50 mm, und eine Spannungsquerschnittsfläche zwischen 50 mm$^2$ und 500 mm$^2$ aufweisen. Wie oben schon erwähnt, werden die Metallhülsen typischerweise mit anderen metallischen Teilen im Kryostaten (z.B. mit dem Vakuumbehälter oder dem Kryogenbehälter) durch Schweißen verbunden. Der beim Schweißen nötige Wärmeeintrag könnte das Kunststoffrohr beschädigen, falls kein ausreichender Abstand zwischen dem Kunststoffrohr und der Schweißnaht liegt. Mit den oben angegebenen Dimensionen ist gewährleistet, dass das Kunststoffrohr während des Einschweißens der Metallhülse nicht unzulässig erwärmt wird.

Eine weitere vorteilhafte Ausführungsform der erfindungsgemäßen Kryostatanordnung zeichnet sich dadurch aus, dass das Außenrohr aus Metall, vorzugsweise aus Edelstahl, gefertigt ist. Metalle zeichnen sich dadurch aus, dass sie als besonders effektive Diffusionsbarriere für Kryogene dienen können. Außerdem ist es sehr einfach, zuverlässige und fluiddichte Verbindungen zwischen Metallen herzustellen (z.B. durch Schweißen, Hartlöten oder Weichlöten). Edelstahl ist eines der weitverbreitetsten Materialien im Kryostatenbau. Seine niedrige Wärmeleitfähigkeit und seine gute Schweißbarkeit macht es prädestiniert für die hier beschriebene Anwendung. Außerdem sind sehr dünnwandige Edelstahlrohre mit Wandstärken von wenigen Zehntelmillimetern leicht kommerziell erhältlich, und lassen sich auch billig durch Rollen und Längsschweißen herstellen. Für Kryostaten von NMR Magnetsystemen sind außerdem die günstigen magnetischen Eigenschaften sowie die niedrige elektrische Leitfähigkeit von Vorteil. So kann die Wärmeleitung innerhalb der Diffusionsbarriere (zusätzlich zur günstigen Materialwahl) weiter verringert werden.

Bei einer bevorzugten Klasse von Ausführungsformen der Erfindung sind innerhalb des Halsrohres, insbesondere innerhalb eines Innenrohrs und/oder zwischen der tragenden Struktur und dem Außenrohr sogenannte Baffles installiert, die Wärmestrahlung abfangen und Konvektion unterbinden. Für den Betrieb des Magnetsystems ist es in mancherlei Hinsicht vorteilhaft, wenn das Innenrohr einen großen Durchmesser hat. Dies erleichtert zum Beispiel, Komponenten, wie Stromzuführungen, Signalleitungen, Ventilstangen, etc., in den Kryogen-behälter einzuführen. Mit steigendem Durchmesser des Innenrohres steigt allerdings auch die Wärmelast auf den Kryogenbehälter - zum einen durch die größere Querschnittsfläche, die für den Transport von Wärmestrahlung und für Wärmeleitung in der Gassäule zu Verfügung steht, und zum anderen durch eine günstigere Geometrie für die Ausbildung von Konvektionswirbeln und thermoakustischen Oszillationen (Takonis-Oszillationen). Werden Baffles im Halsrohr installiert, wird die Wärmestrahlung weitgehend isoliert (die Baffles agieren als gasgekühlte Strahlungsschilde), und die Ausbildung großer Konvektionswirbel und thermoakustischer Oszillationen innerhalb des Innenrohres wird unterbunden. Dabei unterbinden die Baffles den Massenfluss. Die Wärmeleitung in der Gassäule wird verringert, da an jedem Baffle Wärmeübergangswiderstände auftreten.

Besonders bevorzugte Varianten dieser Klasse von Ausführungsformen zeichnen sich dadurch aus, dass die Baffles klappbar ausgeführt sind. Ein nicht unerheblicher Vorteil eines großen Innenrohrdurchmessers besteht darin, dass sich im Falle einer großen Wärmelast auf das Kryogen (z.B. durch einen Bruch des Isolationsvakuums, bei einem supraleitenden Magnetsystem z.B. durch einen Quench) kein großer Druck im Kryogenbehälter aufbauen kann, da ausreichend große Abströmquerschnitte zu Verfügung stehen. Wird der freie Querschnitt des Innenrohrs jedoch mit Baffles verkleinert, fiele dieser Vorteil weg. Es ist daher besonders günstig, die Baffles klappbar auszuführen, sodass sie, sobald es im Inneren des Kryogenbehälters zu einem großen Druckanstieg und deshalb zu einem großen Massenfluss vom Kryogenbehälter in den Bereich außerhalb des Vakuumbehälters kommt, vom ausströmenden Gas nach oben weggeklappt werden, und den Querschnitt des Innenrohrs freigeben.

Vorteilhaft sind auch Ausführungsformen der erfindungsgemäßen Kryostatanordnung mit einer rohrförmigen tragenden Struktur, bei welchen das obere Ende des Innenrohrs im Normalbetrieb fluiddicht verschlossen ist, insbesondere durch ein Überdruckventil oder eine Berstscheibe, sodass im Normalbetrieb abströmendes Kryogen durch den Spalt zwischen Innenrohr und Außenrohr strömen muss. Kaltes Gas, das durch das Verdampfen des flüssigen Kryogens im Kryogenbehälter entsteht, kann im Temperaturbereich zwischen dem Siedepunkt des Kryogens und der Temperatur des Vakuumbehälters noch beträchtliche Kühlleistung bereitstellen. Das kalte Gas streicht beim Abströmen entlang der Rohrwände und absorbiert dabei Wärme, die durch Wärmeleitung innerhalb der Rohrwände vom Vakuumbehälter in den Kryogenbehälter fließt ("Gegenstromkühlung"). Wird das kalte Gas durch den Spalt zwischen Innen- und Außenrohr geleitet, kommt es sowohl mit dem Innenrohr als auch mit dem Außenrohr in thermischen Kontakt, wodurch sich eine besonders effiziente Gegenstromkühlung einrichten lässt. Durch passende Wahl der Spaltgeometrie kann eine gute Balance zwischen einem guten Wärmeübergang des Fluids mit den Wänden des Spalts und dem Druckverlust im strömenden Fluid erreicht werden.

Weitere vorteilhafte Ausführungsformen der Erfindung zeichnen sich dadurch aus, dass der Kryostat einen Joule-Thompson-Kühler enthält, in dem Kryogen mittels einer außerhalb des Vakuumbehälters befindlichen Pumpe entspannt wird, und dass der Spalt zwischen der tragenden Struktur und dem Außenrohr Teil der Verbindungsleitung zwischen dem Joule-Thompson-Kühler und der Pumpe ist. Dadurch lässt sich wiederum der oben schon beschriebene Vorteil nutzen, dass das aus dem Kryostaten abströmende kalte Gas effizient für die Verringerung der Wärmelast durch Wärmleitung genutzt wird. Ein Joule-Thompson-Kühler lässt sich so besonders einfach in einen Kryostaten integrieren, da keine separate Pumpleitung vorgesehen werden muss. Absolute Dichtigkeit zwischen Pumpleitung (Ringspalt) und dem Kryogentank (bzw. dem Volumen im inneren Halsrohr) ist nicht nötig. Ein geringer Leckstrom kann akzeptiert werden, wenn er gering im Vergleich zum Strom ist, der durch den Refrigerator abgepumpt wird.

Weiterhin kann bei Ausführungsformen der erfindungsgemäßen Kryostatanordnung im Außenrohr mindestens ein Balg-Abschnitt vorhanden sein, sodass das Außenrohr keine axialen Kräfte aufnimmt. Wenn das Innen- und das Außenrohr aus unterschiedlichen Materialien gefertigt werden, ist es sehr wahrscheinlich, dass diese beiden Materialien über unterschiedliche thermische Ausdehnungskoeffizienten verfügen. Wird der Kryostat abgekühlt, würden daher in der Halsrohranordnung große mechanische Spannungen entstehen. Diesen Spannungen kann entgegengewirkt werden, wenn im Außenrohr ein Balg installiert wird. Dieser Balg stellt sicher, dass das Rohr weitgehend spannungsfrei bleibt.

Ganz besonders bevorzugt sind Varianten der Erfindung, bei welchen die Kryostatanordnung Teil einer Apparatur zur Kernspinresonanz, insbesondere für Magnetic Resonance Imaging (=MRI) oder für Magnetresonanzspektroskopie (=NMR) ist, die vorzugsweise eine supraleitende Magnetanordnung umfasst. Supraleitende Magnete für MRI oder NMR werden üblicherweise mit flüssigem Helium gekühlt. Jedoch ist die Verfügbarkeit von Helium und dessen Preis ein wesentlicher Faktor, die He-Verluste gering zu halten.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in der Zeichnung dargestellt und wird anhand von Ausführungsbeispielen näher erläutert. Es zeigen:

Fig. 1    eine schematische Vertikalschnittansicht einer ersten Ausführungsform der erfindungsgemäßen Kryostatanordnung;

Fig. 2    eine schematische Vertikalschnittansicht einer zweiten Ausführungsform der erfindungsgemäßen Kryostatanordnung mit Baffles im Halsrohr;

Fig. 3    eine schematische Vertikalschnittansicht einer dritten Ausführungsform der erfindungsgemäßen Kryostatanordnung mit einem Joule-Thompson-Kühler und einer Thermalbarriere im Kryogenbehälter;

Fig. 4    eine schematische Vertikalschnittansicht einer vierten Ausführungsform der erfindungsgemäßen Kryostatanordnung mit einem Balg-Abschnitt im Halsrohr;

Fig. 5a    ein Diagramm des Wärmeleitfähigkeitsintegrals von Edelstahl über der Temperatur nach dem Stand der Technik; und

Fig. 5b    ein Diagramm des Wärmeleitfähigkeitsintegrals von G10 über der Temperatur nach dem Stand der Technik.

Die Figuren 1 bis 4 der Zeichnung zeigen jeweils in einer schematischen Ansicht bevorzugte Ausführungsformen der erfindungsgemäßen Kryostatanordnung zur Aufbewahrung eines fluiden Kryogens, insbesondere für die Kühlung einer supraleitenden Magnetanordnung.

Eine derartige **Kryostatanordnung 1** weist einen **Vakuumbehälter 2** und einen **Kryogenbehälter 3** auf, der innerhalb des Vakuumbehälters 2 angeordnet ist, wobei der Vakuumbehälter 2 mindestens ein **Halsrohr 4** mit einer **tragenden Struktur 4a** und ein die tragende Struktur 4a umgebendes **Außenrohr 4b** aufweist, wobei das Halsrohr 4 zum Kryogenbehälter 3 führt und wobei über das Halsrohr 4 eine räumliche Verbindung eines inneren Volumens des Kryogenbehälters 3 zu einem Bereich außerhalb des Vakuumbehälters 2 hergestellt werden kann, sodass kryogenes Fluid aus dem Kryogenbehälter 3 in einen Bereich außerhalb des Vakuumbehälters 2 strömen kann oder umgekehrt.

Die erfindungsgemäße Kryostatanordnung 1 zeichnet sich gegenüber bekannten Vorrichtungen aus dem Stand der Technik dadurch aus, dass die zu einer mechanischen Aufhängung des Kryogenbehälters 3 am Vakuumbehälter 2 dienenden Teile des Halsrohrs 4 einerseits und die zur Errichtung einer Diffusionsbarriere zwischen dem Innenraum des Kryogenbehälters 3 und dem Innenraum des Vakuumbehälters 2 dienenden Teile des Halsrohrs 4 andererseits räumlich voneinander getrennt angeordnet und aus unterschiedlich jeweils optimierten Materialien gefertigt sind, dass die tragende Struktur 4a das Gewicht des Kryogenbehälters 3 trägt und aus einem Material gefertigt ist, bei welchem für das Verhältnis $\sigma/\theta$ von maximal zulässiger mechanischer Spannung $\sigma$, mit $\sigma > 100$ MPa, zum Integral $\theta$ der Wärmeleitfähigkeit $\lambda$ über den Temperaturbereich $\Delta T$ zwischen 300 K und 4 K, mit $\theta < 300$ W/m, gilt:

$$\sigma/\theta > 1/3 \ (\text{MPa·m})/\text{W},$$

und dass das Außenrohr 4b aus einem Material gefertigt ist, durch welches kryogenes Fluid nicht oder nur in praktisch nicht-messbarer Menge diffundieren kann, und welches mit anderen Komponenten der Kryostatanordnung 1 fluiddicht verbunden werden kann, so dass die resultierende integrale Leckrate aus dem Kryogenbehälter 3 in den Vakuumbehälter 2 kleiner ist als $10^{-4}$ Pa·l/s ($10^{-6}$ mbar·l/s).

Bei den in den Figuren 1 bis 4 der Zeichnung dargestellten Ausführungsformen der Erfindung ist die tragende Struktur 4a in Form eines Innenrohres ausgebildet, und über das Innenrohr kann eine räumliche Verbindung des inneren Volumens des Kryogenbehälters 3 zu einem Bereich außerhalb des Vakuumbehälters 2 hergestellt werden, sodass kryogenes Fluid aus dem Kryogenbehälter 3 in einen Bereich außerhalb des Vakuumbehälters 2 strömen kann oder umgekehrt. Dabei kann das Außenrohr 4b in direktem, vorzugsweise thermisch gut leitenden, Kontakt mit dem Innenrohr stehen - was in der Zeichnung allerdings nicht dargestellt ist. Alternativ kann - wie in den Figuren 1 bis 4 gezeigt- das Außenrohr 4b zum Innenrohr beabstandet sein, und zwischen dem Innenrohr und dem Außenrohr 4b ein **Spalt 4c** offenbleiben. In diesem Fall sind das Außenrohr 4b und das Innenrohr vorzugsweise durch mehrere axial angeordnete, radial verlaufende Wärmebrücken miteinander verbunden.

Wie in den Figuren 1, 2 und 4 zu erkennen ist, wird abströmendes Kryogen durch den Ringspalt 4c zwischen dem Innenrohr 4a und dem Außenrohr 4b hindurchgeleitet, um die Enthalpie des kalten Gases bestmöglich für das Abfangen der Wärme zu nutzen, die vom Außenbehälter (also dem Vakuumbehälter 2) entlang des Halsrohres 4 in den Kryogentank 3 fließt.

Das äußere Rohr 4b stellt die Dichtigkeit zum Isolationsvakuum her. Die Wandstärke wird so ausgelegt, dass der maximale Differenzdruck zwischen dem Ringspalt 4c und dem Isolationsvakuum aufgenommen werden kann, und dass keine nennenswerte Diffusion des Kryogens ins Isolationsvakuum stattfindet. Das Material wird so gewählt, dass eine dichte Verbindung zu anderen Teilen des Kryostaten (z.B. die Deckelplatte des Kryogentanks 3) zuverlässig und billig hergestellt werden kann. Das äußere Rohr 4b kann z.B. aus Edelstahl hergestellt werden, das über ausgezeichnete Schweißeigenschaften verfügt. Die Wandstärke dieses Rohres kann sehr dünn gewählt werden, da das Rohr *nicht* das gesamte Gewicht des Kryogentanks 3 (und der darin befindlichen Komponenten) aufnehmen muss.

Das innere Rohr 4a trägt das Gewicht des Kryogentanks 3. Es muss allerdings nicht hermetisch dicht sein, weshalb ein Material gewählt werden kann, das sich primär durch das hohe Verhältnis von mechanischer Festigkeit und Wärmeleitfähigkeit auszeichnet. Hier kommen z.B. faserverstärkte Kunststoffe in Frage. So kann etwa die tragende Struktur 4a insbesondere aus GFK, besonders bevorzugt aus dem Faserverbundwerkstoff G10, gefertigt sein. Das GFK-Rohr wird an beiden Enden mit einer Edelstahlhülse verbunden. Verbindungsmöglichkeiten zwischen GFK und Edelstahlhülse sind dem Fachmann bekannt. Die Edelstahlhülse muss eine gewisse Mindestlänge aufweisen (typischerweise 50 mm).

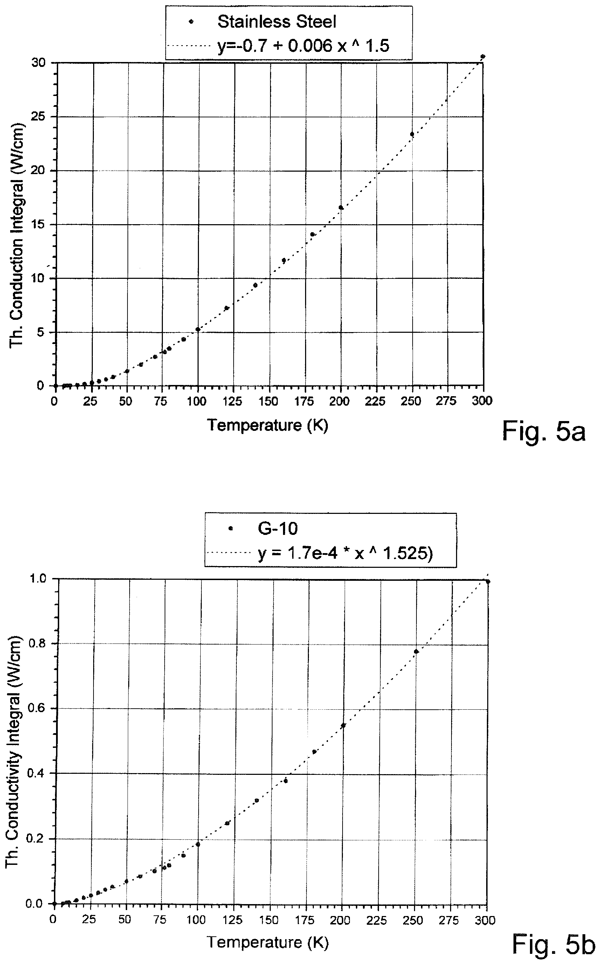

Die Abbildungen der Figuren 5a und 5b zeigen die Wärmeleitfähigkeitsintegrale für Edelstahl (fig. 5a) und für den Faserverbundwerkstoff G10 (Fig. 5b; Quelle: jeweils J.W. Kooi, Caltech). Wie man sieht, ist das Wärmeleitfähigkeitsintegral von Edelstahl etwa 30-mal größer als das von G10. Allerdings ist Edelstahl auch erheblich fester als G10, weshalb als Kennzahl das Verhältnis aus Festigkeit zu Wärmeleitfähigkeit herangezogen werden muss. Die 0.2 % Streckgrenze von Edelstahl, die zur Auslegung herangezogen würde, beträgt typischerweise 360 MPa (für 1.4301); die Zugfestigkeit von G10 liegt bei etwa 270 MPa.

Selbst unter der konservativen Annahme, dass bei G10 ein Sicherheitsfaktor von 3 gegenüber der Zugfestigkeit angewandt wird und dass Edelstahl bis an die Streckgrenze belastet werden kann, ist die Wärmeleitung über ein Edelstahlrohr $[(270/3 \text{ MPa})/(1 \text{ W/cm})]/[(360 \text{ MPa})/(30 \text{ W/cm})]= 7{,}5$ mal so groß wie über ein GFK Rohr mit der gleichen Tragfähigkeit.

Die tragende Struktur 4a aus Kunststoff trägt an ihren beiden Enden jeweils einen **Metallfortsatz 5a', 5a",** vorzugsweise aus Edelstahl. Die Metallfortsätze 5a', 5a" weisen jeweils eine Länge zwischen 20 mm und 100 mm, vorzugsweise etwa 50 mm, und eine Spannungsquerschnittsfläche zwischen 50 $mm^2$ und 500 $mm^2$ auf.

Wie in Fig. 1 gezeigt, kann bei einfachen Ausführungsformen der Erfindung das obere Ende des Innenrohrs 4a im Normalbetrieb fluiddicht verschlossen sein, insbesondere durch ein Überdruckventil oder eine **Berstscheibe 9,** sodass im Normalbetrieb abströmendes kryogenes Fluid durch den Spalt 4c zwischen Innenrohr 4a und Außenrohr 4b strömen muss. Der Spalt 4c zwischen dem Innenrohr 4a und dem Außenrohr 4b weist an dem Kryogenbehälter 3 näherliegenden Ende des Halsrohrs 4 eine **Strömungsdrossel 7** auf.

In Fig. 2 ist eine dazu alternative Ausführungsform der Erfindung dargestellt, bei welcher innerhalb des Halsrohres 4, insbesondere innerhalb des Innenrohrs und/oder zwischen der tragenden Struktur 4a und dem Außenrohr 4b sogenannte **Baffles 6** installiert sind, die Wärmestrahlung abfangen und Konvektion unterbinden. Die Baffles 6 sind vorzugsweise klappbar ausgeführt, damit sie im Falle eines schnellen Abströmens des Kryogens (z.B. im Quenchfall) den Querschnitt des inneren Rohres 4a freigeben, und auf diese Weise den Druckanstieg im Kryogentank 3 begrenzen.

Der Ringspalt 4c kann bei anderen Ausführungsformen der Erfindung auch als Pumpleitung für unterkühlte Systeme dienen. Wenn der Eingang der Pumpleitung durch eine Drossel geschützt ist, muss der Quenchdruck bei der Dimensionierung des äußeren Rohr 4b nicht berücksichtigt werden. Absolute Dichtigkeit zwischen Pumpleitung (Ringspalt 4c) und dem Kryogentank 3 (bzw. dem Volumen im inneren Rohr 4a) ist nicht nötig. Ein geringer Leckstrom kann akzeptiert werden, wenn er klein im Vergleich zum Strom ist, der durch den Refrigerator abgepumpt wird.

Fig. 3 illustriert eine derartig ausgestaltete Ausführungsform, bei welcher der Kryostat einen **Joule-Thompson-Kühler JT** enthält, in dem kryogenes Fluid mittels einer außerhalb des Vakuumbehälters 2 befindlichen -in der Zeichnung nicht dargestellten- Pumpe entspannt wird, wobei der Spalt 4c zwischen der tragenden Struktur 4a und dem Außenrohr 4b Teil der Verbindungsleitung zwischen dem Joule-Thompson-Kühler JT und der Pumpe ist. In Fig. 3 ist ein Kryogentank gezeigt, der mittels einer **Thermalbarriere 20** in zwei Bereiche unterteilt wird. Die Thermalbarriere 20 ist thermisch isolierend, ermöglich aber den Druckausgleich zwischen den beiden Bereichen (z.B. eine flexible Membran aus thermisch isolierendem Material). Oberhalb der thermischen Barriere befindet sich beispielsweise Kryogen bei Atmosphärendruck im Sättigungszustand. Unterhalb der Barriere ist das Kryogen im unterkühlten Zustand (d.h. Atmosphärendruck, aber eine Temperatur, die unterhalb der Gleichgewichtstemperatur liegt). Dafür muss vom Joule-Thompson-Kühler JT Wärme abgeführt werden. Eine solche Anordnung eignet sich ideal zum Betrieb von supraleitenden Magnetspulen bei Temperaturen unterhalb von 4.2 K.

Um eine mechanische Überbestimmung des Systems zu vermeiden, kann im äußeren Rohr 4b ein **Balg-Abschnitt 8** vorgesehen sein. Damit kann das äußere Rohr 4b keine axialen Kräfte aufnehmen, und kann durch axiale Kräfte deshalb auch nicht über die Maßen strapaziert werden. Eine derartig modifizierte Ausführungsform der Erfindung ist in Fig. 4 dargestellt.

Denkbar sind auch Ausführungsformen der Erfindung, bei welchen unter Verzicht auf die Abgaskühlung im Ringspalt 4c oder der Verfügbarkeit als Pumpleitung eine Variante ohne Ringspalt umgesetzt ist, oder bei denen das die tragende Struktur -anders als in den Abbildungen gezeigt- nicht als Rohr, sondern als einzelner Stab oder mehrere Stäbe ausgeführt wird.

Die Merkmale aller oben beschriebenen Ausführungsformen der Erfindung können -größtenteils- auch miteinander kombiniert werden, innerhalb des von den Ansprüchen vorgegebenen Schutzumfangs.

## Patentansprüche

1. Kryostatanordnung (1) mit einem Vakuumbehälter (2) und einem Kryogenbehälter (3), der innerhalb des Vakuumbehälters (2) angeordnet ist, wobei der Vakuumbehälter (2) mindestens ein Halsrohr (4) mit einer tragenden Struktur (4a) und ein die tragende Struktur (4a) umgebendes Außenrohr (4b) aufweist, wobei das Halsrohr (4) zum Kryogenbehälter (3) führt und wobei über das Halsrohr (4) eine räumliche Verbindung eines inneren Volumens des Kryogenbehälters (3) zu einem Bereich außerhalb des Vakuumbehälters (2) hergestellt werden kann, sodass kryogenes Fluid aus dem Kryogenbehälter (3) in einen Bereich außerhalb des Vakuumbehälters (2) strömen kann oder umgekehrt, **dadurch gekennzeichnet,** **dass** das Halsrohr (4) so gestaltet ist, dass die Funktionen einer mechanischen Befestigung des Kryogenbehälters (3) einerseits und einer Dichtigkeit der Halsrohrwand andererseits voneinander getrennt sind, indem zu einer mechanischen Aufhängung des Kryogenbehälters (3) am Vakuumbehälter (2) dienende Teile des Halsrohrs (4) einerseits und zur Errichtung einer Diffusionsbarriere zwischen dem Innenraum des Kryogenbehälters (3) und dem Innenraum des Vakuumbehälters (2) dienende Teile des Halsrohrs (4) andererseits räumlich voneinander getrennt angeordnet und aus jeweils unterschiedlich optimierten Materialien gefertigt sind, dass die tragende Struktur (4a) aus Kunststoff gefertigt ist und an ihren beiden Enden jeweils einen Metallfortsatz (5a', 5a") zur Verbindung mit dem Vakuum- bzw. dem Kryogenbehälter aufweist, dass die tragende Struktur (4a) das Gewicht des Kryogenbehälters (3) trägt und aus einem Material gefertigt ist, bei welchem für das Verhältnis σ/θ von maximal zulässiger mechanischer Spannung σ, mit σ > 100 MPa, zum Integral θ der Wärmeleitfähigkeit λ über den Temperaturbereich ΔT zwischen 300 K und 4 K, mit θ < 300 W/m, gilt:

$$\sigma/\theta > 1/3 \ (\text{MPa·m})/\text{W},$$

und dass das Außenrohr (4b) aus einem Material gefertigt ist, durch welches kryogenes Fluid nicht oder nur in praktisch nicht-messbarer Menge diffundieren kann, und welches mit anderen Komponenten der Kryostatanordnung (1) fluiddicht verbunden ist, so dass die resultierende integrale Leckrate aus dem Kryogenbehälter (3) in den Vakuumbehälter (2) kleiner ist als $10^{-4}$ Pa·l/s (10 mbar·l/s).

2. Kryostatanordnung nach Anspruch 1, **dadurch gekennzeichnet, dass** die tragende Struktur (4a) in Form eines Innenrohres ausgebildet ist, und über das Innenrohr eine räumliche Verbindung des inneren Volumens des Kryogenbehälters (3) zu einem Bereich außerhalb des Vakuumbehälters (2) hergestellt werden kann, sodass kryogenes Fluid aus dem Kryogenbehälter (3) in einen Bereich außerhalb des Vakuumbehälters (2) strömen kann oder umgekehrt.

3. Kryostatanordnung nach Anspruch 2, **dadurch gekennzeichnet, dass** das Außenrohr (4b) in direktem, vorzugsweise thermisch gut leitenden, Kontakt mit dem Innenrohr steht.

4. Kryostatanordnung nach Anspruch 2, **dadurch gekennzeichnet, dass** das Außenrohr (4b) zum Innenrohr beabstandet ist, und zwischen dem Innenrohr und dem Außenrohr (4b) ein Spalt (4c) offenbleibt.

5. Kryostatanordnung nach Anspruch 4, **dadurch gekennzeichnet, dass** das Außenrohr (4b) und das Innenrohr durch mehrere axial angeordnete, radial verlaufende Wärmebrücken miteinander verbunden sind.

6. Kryostatanordnung nach einem der vorhergehenden Ansprüche, **dadurch gekennzeichnet, dass** die tragende Struktur (4a) aus faserverstärktem Kunststoff, insbesondere aus GFK, besonders bevorzugt aus dem Faserverbundwerkstoff G10, ge-

EP 3 382 411 B1

fertigt ist.

7. Kryostatanordnung nach einem der vorhergehenden Ansprüche, **dadurch gekennzeichnet, dass** die Metallfortsätze (5a', 5a") aus Edelstahl bestehen.

8. Kryostatanordnung nach Anspruch 7, **dadurch gekennzeichnet, dass** die Metallfortsätze (5a', 5a") jeweils eine Länge zwischen 20 mm und 100 mm, vorzugsweise etwa 50 mm, und eine Spannungsquerschnittsfläche zwischen 50 mm$^2$ und 500 mm$^2$ aufweisen.

9. Kryostatanordnung nach einem der vorhergehenden Ansprüche, **dadurch gekennzeichnet, dass** das Außenrohr (4b) aus Metall, vorzugsweise aus Edelstahl, gefertigt ist.

10. Kryostatanordnung nach einem der vorhergehenden Ansprüche, **dadurch gekennzeichnet, dass** innerhalb des Halsrohres (4), insbesondere innerhalb eines Innenrohrs (4a) und/oder zwischen der tragenden Struktur (4a) und dem Außenrohr (4b) Baffles (6) installiert sind, die Wärmestrahlung abfangen und Konvektion unterbinden.

11. Kryostatanordnung nach Anspruch 10, **dadurch gekennzeichnet, dass** die Baffles (6) klappbar ausgeführt sind.

12. Kryostatanordnung nach Anspruch 4 und gegebenenfalls einem der Ansprüche 5 bis 11, **dadurch gekennzeichnet, dass** das obere Ende des Innenrohrs (4a) im Normalbetrieb fluiddicht verschlossen ist, insbesondere durch ein Überdruckventil oder eine Berstscheibe (9), sodass im Normalbetrieb abströmendes kryogenes Fluid durch den Spalt (4c) zwischen Innenrohr (4a) und Außenrohr (4b) strömen muss.

13. Kryostatanordnung nach Anspruch 4 und gegebenenfalls einem der Ansprüche 5 bis 12, sofern von Anspruch 4 abhängig, **dadurch gekennzeichnet, dass** der Kryostat einen Joule-Thompson-Kühler (JT) enthält, in dem kryogenes Fluid mittels einer außerhalb des Vakuumbehälters (2) befindlichen Pumpe entspannt wird, und dass der Spalt (4c) zwischen der tragenden Struktur (4a) und dem Außenrohr (4b) Teil der Verbindungsleitung zwischen dem Joule-Thompson-Kühler (JT) und der Pumpe ist.

14. Kryostatanordnung nach Anspruch 4 sowie gegebenenfalls einem der Ansprüche 5 bis 13, sofern von Anspruch 4 abhängig, **dadurch gekennzeichnet, dass** der Spalt (4c) zwischen dem Innenrohr (4a) und dem Außenrohr (4b) an dem dem Kryogenbehälter (3) näherliegenden Ende des Halsrohrs (4) eine Strömungsdrossel (7) aufweist.

15. Kryostatanordnung nach einem der vorhergehenden Ansprüche, **dadurch gekennzeichnet, dass** im Außenrohr (4b) mindestens ein Balg-Abschnitt (8) vorhanden ist, sodass das Außenrohr (4b) keine axialen Kräfte aufnimmt.

**Claims**

1. Cryostat arrangement (1), comprising a vacuum tank (2) and a cryogenic tank (3), which is arranged inside the vacuum tank (2),
the vacuum tank (2) having at least one neck tube (4) having a supporting structure (4a) and an outer tube (4b) surrounding the supporting structure (4a), the neck tube (4) leading to the cryogenic tank (3) and, by means of the neck tube (4), a spatial connection of an internal volume of the cryogenic tank (3) to a region outside the vacuum tank (2) being able to be produced so that cryogenic fluid can flow out of the cryogenic tank (3) into a region outside the vacuum tank (2) or vice versa,
**characterized in that,**
the neck tube (4) is designed such that the functions of mechanical mounting of the cryogenic tank (3) on the one hand and tightness of the neck tube wall on the other hand are separate from one another **in that** on the one hand the parts of the neck tube (4) used to mechanically suspend the cryogenic tank (3) on the vacuum tank (2), and on the other hand the parts of the neck tube (4) used to construct a diffusion barrier between the interior of the cryogenic tank (3) and the interior of the vacuum tank (2) are arranged so as to be spatially separated from one another and are produced from materials which are optimized differently in each case,
**in that** the supporting structure (4a) is produced from plastic material and comprises at each of its two ends one metal extension (5a', 5a") for connection to the vacuum tank or cryogenic tank,
**in that** the supporting structure (4a) supports the weight of the cryogenic tank (3) and is produced from a material in the case of which, for the ratio $\sigma/\theta$ of a maximum permissible mechanical stress $\sigma$, where $\sigma > 100$ MPa, to the integral $\theta$ of the thermal conductivity A over the temperature range $\Delta T$ between 300 K and 4 K, where $\theta < 300$ W/m, the following applies:

$$\sigma/\theta > 1/3 \ (\text{MPa·m})/\text{W},$$

and **in that** the outer tube (4b) is produced from a material through which cryogenic fluid cannot diffuse, or through which only a virtually unmeasurable amount of cryogenic fluid can diffuse in practice, and which tube is connected to other components of the cryostat arrangement (1) in a fluid-tight manner so that the resulting integral leakage rate out of the cryogenic tank (3) into the vacuum tank (2) is less than $10^{-4}$Pa·l/s ($10^{-6}$mbar·l/s).

2. Cryostat arrangement according to claim 1, **characterized in that** the supporting structure (4a) is in the form of an inner tube, and, by means of the inner tube, a spatial connection of the internal volume of the cryogenic tank (3) to a region outside the vacuum tank (2) can be produced so that cryogenic fluid can flow from the cryogenic tank (3) into a region outside the vacuum tank (2) or vice versa.

3. Cryostat arrangement according to claim 2, **characterized in that** the outer tube (4b) is in direct, preferably thermally well-conducting, contact with the inner tube.

4. Cryostat arrangement according to claim 2, **characterized in that** the outer tube (4b) is at a distance from the inner tube, and a gap (4c) remains open between the inner tube and the outer tube (4b).

5. Cryostat arrangement according to claim 4, **characterized in that** the outer tube (4b) and the inner tube are interconnected by a plurality of axially arranged, radially extending thermal bridges.

6. Cryostat arrangement according to any of the preceding claims, **characterized in that** the supporting structure (4a) is produced from fiber-reinforced plastics material, in particular from GFRP, more preferably from the fiber-reinforced composite G10.

7. Cryostat arrangement according to any of the preceding claims, **characterized in that** the metal extensions (5a', 5a") consist of stainless steel.

8. Cryostat arrangement according to claim 7, **characterized in that** the metal extensions (5a', 5a") each have a length of between 20 mm and 100 mm, preferably approximately 50 mm, and a cross-sectional area of stress of between 50 mm$^2$ and 500 mm$^2$.

9. Cryostat arrangement according to any of the preceding claims, **characterized in that** the outer tube (4b) is produced from metal, preferably from stainless steel.

10. Cryostat arrangement according to any of the preceding claims, **characterized in that**, inside the neck tube (4), in particular inside an inner tube (4a) and/or between the supporting structure (4a) and the outer tube (4b), baffles (6) are installed, which absorb thermal radiation and prevent convection.

11. Cryostat arrangement according to claim 10, **characterized in that** the baffles (6) are foldable.

12. Cryostat arrangement according to claim 4 and optionally any of claims 5 to 11, **characterized in that** the upper end of the inner tube (4a) is closed in a fluid-tight manner in normal operation, in particular by a pressure relief valve or a rupture disk (9), so that cryogenic fluid flowing away in normal operation has to flow through the gap (4c) between the inner tube (4a) and the outer tube (4b).

13. Cryostat arrangement according to claim 4 and optionally any of claims 5 to 12 in as far as dependent on claim 4, **characterized in that** the cryostat contains a Joule-Thomson cooler (JT), in which cryogenic fluid is depressurized by means of a pump located outside the vacuum tank (2), and **in that** the gap (4c) between the supporting structure (4a) and the outer tube (4b) is part of the connecting line between the Joule-Thomson cooler (JT) and the pump.

14. Cryostat arrangement according to claim 4 and optionally any of claims 5 to 13 in as far as dependent on claim 4, **characterized in that** the gap (4c) between the inner tube (4a) and the outer tube (4b) comprises a flow restrictor (7) at the end of the neck tube (4) which is closer to the cryogenic tank (3).

15. Cryostat arrangement according to any of the preceding claims, **characterized in that**, in the outer tube (4b), there is at least one bellows portion (8) so that the outer tube (4b) does not absorb any axial forces.

**Revendications**

1. Dispositif cryostatique (1) comportant un récipient à vide (2) et un récipient cryogénique (3) disposé à l'intérieur du récipient à vide (2), le récipient à vide (2) comportant au moins un col tubulaire (4) avec une structure porteuse (4a) et un tube extérieur (4b) entourant la structure porteuse (4a), dans lequel le col tubulaire (4) conduit au récipient cryogénique (3) et dans lequel une liaison spatiale entre un volume intérieur du récipient cryogénique (3) et une zone extérieure au récipient à vide (2) peut être établie via le col tubulaire (4), de sorte que du fluide cryogénique peut s'écouler du récipient cryogénique (3) dans une zone extérieure au récipient à vide (2) ou inversement,
**caractérisé en ce que** le col tubulaire (4) est configuré de sorte que les fonctions d'une fixation mécanique du récipient cryogénique (3), d'une part, et d'une étanchéité de la paroi de col tubulaire, d'autre part, soient séparées l'une de l'autre par le fait que des parties du col tubulaire (4) qui servent à suspendre mécaniquement le récipient cryogénique (3) au récipient à vide (2), d'une part, et des parties du col tubulaire (4) qui servent à créer une barrière de diffusion entre l'espace intérieur du récipient cryogénique (3) et l'espace intérieur du récipient à vide (2), d'autre part, sont disposées séparément les unes des autres spatialement et fabriquées en matériaux optimisés différemment,

**que** la structure porteuse (4a) est fabriquée en matière plastique et présente à ses deux extrémités un prolongement métallique respectif (5a', 5a") pour la liaison avec le récipient à vide, respectivement le récipient cryogénique,

**que** la structure porteuse (4a) porte le poids du récipient cryogénique (3) et est fabriquée dans un matériau pour lequel le rapport $\sigma/\theta$ de la contrainte mécanique maximale admissible $\sigma$, avec $\sigma > 100$ MPa, sur l'intégrale $\sigma$ de la conductivité thermique $\lambda$ sur la plage de température $\Delta T$ entre 300 K et 4 K, avec $\theta < 300$ W/m, est :

$$\sigma/\theta > 1/3 \text{ (MPa·m)/W,}$$

et que le tube extérieur (4b) est fabriqué dans un matériau à travers lequel le fluide cryogénique ne peut pas diffuser ou ne peut diffuser qu'en quantité pratiquement non mesurable, et qui est relié de manière étanche aux fluides à d'autres composants du dispositif cryostatique (1), de sorte que le taux de fuite intégral résultant du récipient cryogénique (3) dans le récipient à vide (2) est inférieur à $10^{-4}$ Pa·l/s ($10^{-6}$ mbar·l/s).

2. Dispositif cryostatique selon la revendication 1, **caractérisé en ce que** la structure porteuse (4a) est réalisée sous la forme d'un tube intérieur et une liaison spatiale entre le volume intérieur du récipient cryogénique (3) et une zone extérieure au récipient à vide (2) peut être établie via le tube intérieur, de sorte que du fluide cryogénique peut s'écouler du récipient cryogénique (3) dans une zone extérieure au récipient à vide (2) ou inversement.

3. Dispositif cryostatique selon la revendication 2, **caractérisé en ce que** le tube extérieur (4b) est en contact direct, de préférence bon conducteur thermiquement, avec le tube intérieur.

4. Dispositif cryostatique selon la revendication 2, **caractérisé en ce que** le tube extérieur (4b) est espacé du tube intérieur et qu'une fente (4c) reste ouverte entre le tube intérieur et le tube extérieur (4b).

5. Dispositif cryostatique selon la revendication 4, **caractérisé en ce que** le tube extérieur (4b) et le tube intérieur sont reliés l'un à l'autre par plusieurs ponts thermiques disposés axialement et s'étendant radialement.

6. Dispositif cryostatique selon l'une des revendications précédentes, **caractérisé en ce que** la structure porteuse (4a) est fabriquée en matière plastique renforcée par des fibres, en particulier en GFK, de préférence en matériau composite fibreux G10.

7. Dispositif cryostatique selon l'une des revendications précédentes, **caractérisé en ce que** les prolongements métalliques (5a', 5a") sont en acier inoxydable.

8. Dispositif cryostatique selon la revendication 7, **caractérisé en ce que** les prolongements métalliques (5a', 5a") ont chacun une longueur comprise entre 20 mm et 100 mm, de préférence d'environ 50 mm, et une section transversale de contrainte comprise entre 50 mm$^2$ et 500 mm$^2$.

9. Dispositif cryostatique selon l'une des revendications précédentes, **caractérisé en ce que** le tube extérieur (4b) est fabriqué en métal, de préférence en acier inoxydable.

10. Dispositif cryostatique selon l'une des revendications précédentes, **caractérisé en ce que** des chicanes (6) sont installées à l'intérieur du col tubulaire (4), en particulier à l'intérieur d'un tube intérieur (4a) et/ou entre la structure porteuse (4a) et le tube extérieur (4b), lesquelles interceptent le rayonnement thermique et empêchent la convection.

11. Dispositif cryostatique selon la revendication 10, **caractérisé en ce que** les chicanes (6) sont réalisées rabattables.

12. Dispositif cryostatique selon la revendication 4 et le cas échéant l'une des revendications 5 à 11, **caractérisé en ce que** l'extrémité supérieure du tube intérieur (4a) est fermée de manière étanche aux fluides en fonctionnement normal, en particulier par une soupape de surpression ou un disque de rupture (9), de sorte que du fluide cryogénique circulant en fonctionnement normal doit s'écouler à travers la fente (4c) entre le tube intérieur (4a) et le tube extérieur (4b).

13. Dispositif cryostatique selon la revendication 4 et le cas échéant l'une des revendications 5 à 12, si elle dépend de la revendication 4, **caractérisé en ce que** le cryostat contient un refroidisseur Joule-Thompson (JT) dans lequel du fluide cryogénique est détendu au moyen d'une pompe située à l'extérieur du récipient à vide (2) et que la fente (4c) entre la structure porteuse (4a) et le tube extérieur (4b) fait partie de la conduite de liaison entre le refroidisseur Joule-Thompson (JT) et la pompe.

14. Dispositif cryostatique selon la revendication 4 et le cas échéant l'une des revendications 5 à 13, si elle dépend de la revendication 4, **caractérisé en ce que** la fente (4c) entre le tube intérieur (4a) et le tube extérieur (4b) présente un étranglement (7) à l'extrémité du col tubulaire (4) proche du récipient cryogénique (3).

15. Dispositif cryostatique selon l'une des revendications précédentes, **caractérisé en ce qu'**au moins une section formant soufflet (8) est présente dans le tube extérieur (4b), de sorte que le tube extérieur (4b) ne subit aucune force axiale.

Fig. 1

Fig. 2

Fig. 3

Fig. 4

Fig. 5a

Fig. 5b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5220800 A